## Europäisches Patentamt
## European Patent Office
## Office européen des brevets

(11) Publication number: **0 040 540**
**B1**

(12) **EUROPEAN PATENT SPECIFICATION**

(45) Date of publication of patent specification: **21.01.87**

(21) Application number: **81302204.3**

(22) Date of filing: **19.05.81**

(51) Int. Cl.⁴: **G 05 D 7/06,** G 05 D 11/00, G 01 F 1/68

(54) **Chemical vapor delivery system and method for controlling the flow of vapor in a chemical vapor delivery system.**

(30) Priority: **20.05.80 US 151741**

(43) Date of publication of application:
**25.11.81 Bulletin 81/47**

(45) Publication of the grant of the patent:
**21.01.87 Bulletin 87/04**

(84) Designated Contracting States:
**DE FR GB NL**

(56) References cited:
DE-A-2 734 582
DE-A-2 738 531
US-A-3 650 151
US-A-4 134 514
US-A-4 140 735
US-A-4 204 612

NAVY TECHNICAL DISCLOSURE BULLETIN,
vol. V, no. 3, March 1980, Arlington, B.R.SAID
et al. "Feedback controlled flow regulator",
pages 27-31

The file contains technical information
submitted after the application was filed and
not included in this specification

(73) Proprietor: **J.C. SCHUMACHER COMPANY**
**580 Airport Road**
**Oceanside California 92054 (US)**

(72) Inventor: **McMenamin, Joseph C.**
**3391 Jibsail Street**
**Oceanside California 92054 (US)**

(74) Representative: **McCall, John Douglas et al**
**W.P. THOMPSON & CO. Coopers Building**
**Church Street**
**Liverpool L1 3AB (GB)**

(56) References cited:
**ADVANCES IN INSTRUM. vol. 33, Part 1, 1978,**
**Pittsburgh, A.W. LANGILL, JR. "All-digital**
**control and metering of fuel gases to a steam**
**boiler", pages 269-274**

Courier Press, Leamington Spa, England.

## Description

This invention relates to an improved system for controlling the flow of vapor transported by a carrier gas from a bubbler to a using system. The control system is particularly useful in connection with high purity liquid source material used in the manufacturing of semiconductor devices.

The fabrication of semiconductor electronic devices includes many steps which require the transport of particular atoms or molecules to the surfaces of wafer substrates, usually maintained at elevated temperatures. In many of the steps, the most common method for accomplishing this is to transport the vapors from a liquid chemical source by a carrier gas stream into a reaction chamber of the using system. Consistent device performance depends strongly on accurate vapor delivery rates and extremely low levels of impurities, particularly metallics.

Typically, an ultra-high purity liquid source material is provided in a bubbler, and a suitable carrier gas stream is bubbled through the liquid and then transported to the point of use. The previous methods vapor flow control that have been customarily used are the thermal-conductivity mass flow meter and the temperature controlled vaporizer bubbler; however, neither method has been entirely satisfactory.

The thermal conductivity mass flow meter monitors the vapor flow from a liquid source bubbler by taking the ratio of the thermal-conductivity of the carrier gas and vapor mixture flowing out of the bubbler, to the thermal-conductivity of the carrier gas flowing into the bubbler (see for example U.S. Patent 3,650,151). The main drawback of this method is the introduction of metallic contamination in the vapor stream. The design and construction of the thermal mass flow meter has necessitated the use of metallic parts, usually stainless steel, in the chemical vapor path. Because of the highly corrosive nature of many of the commonly used chemical vapors (especially in the presence of trace levels of moisture contamination) the metallic parts slowly deteriorate and the resulting metallic impurities are carried with the source vapor to the wafers. This leads not only to wafer contamination and low device yields, but also to drift and failure in the mass flow controller caused by the chemical deterioration. In addition the cost of the meters themselves is not a small problem in that they are costly, in the area of U.S. $2,000, and must be frequently repaired and replaced. This is particularly so with high carrier gas flow, such as in fibre optic applications.

The temperature controlled bubbler method maintains constant vapor mass flow by closely controlling the bubbler temperature and the mass flow rate of the carrier gas stream. Recently introduced improved bubblers, such as those illustrated in U.S. Patents 4,134,514 and 4,140,735 eliminate many contamination and deterioration problems by using only high-purity quartz and Teflon in contact with the vapors, and by eliminating chemical handling problems ("Teflon" is a Trade Mark). The main drawback to this method has been fluctuations in the vapor mass flow such that the output has not always been sufficiently satisfactory and has required considerable trial and error adjusting of the carrier gas stream. As a result of inadequate controls, there is a significant and frequent loss of partially finished goods. In addition, there have been some reported instances of connections being broken or bubblers exploding because of improperly high pressures of the carrier gas streams. This results in danger to operating personnel because of the corrosive nature of the liquid source material, as well as the possible loss of the expensive work in progress, such as a batch of semiconductor wafers. Accordingly, a need exists for improved flow control of such a bubbler system. The present invention relates to such an improvement for the temperature controlled type bubbler system.

In the operation of temperature controlled bubbler systems, it had been assumed that maintaining a reasonably accurate control of the temperature of the liquid source material and monitoring the flow of the carrier gas would provide sufficient consistency of the vapor flow, since the saturation point of the carrier gas varies with temperature. However, close analysis has revealed a number of sources of error.

For example, it had been assumed that there was no need to monitor pressure in that the using system was at atmospheric pressure and that therefore the vapor pressure within the bubbler was substantially at atmospheric. It has been learned that simple changes in atmospheric pressure can produce an undesirable error in the vapor mass flow. Further, the existence of valves downstream from the bubbler can introduce back pressure variations such that the bubbler vapor pressure is above atmospheric pressure. Related to this, simply the length of the fluid line from the bubbler to the using system introduces variations in back pressure.

Also, it has been discovered that variation in the size of the opening through which the gas passes in exiting the bubbler can introduce pressure variations that result in a source of error. Typically, a thin glass seal in the bubbler inlet had been broken by magnetically raising a small metal ball and dropping it to break the seal. Variations in the size of the opening can affect the accuracy of the system, and use of the present invention accommodates such variations.

It has further been found that certain errors are introduced into the system by temperature variations that are not sufficiently accommodated by the means employed for maintaining the liquid source material at constant temperature. For example, sudden ambient temperature changes, such as that caused by opening a nearby oven door, can introduce temporary errors that cannot be quickly corrected by a temperature controller. Further, in some uses of the system such as the fabrication of fiber optics, a relatively large flow of carrier gas is required. It has been found that this increased carrier gas flow rate can introduce significant evaporative cooling such that ten to fifteen minutes may be required to stabilize the temperature. This of course results in the loss of very expensive bubbler vapor as well as delaying the manufacturing process.

Related to the high carrier gas flow rate situation, it was commonly thought that an increased flow rate would result in the carrier gas not being saturated as it bubbled through the liquid source material; however, while this is true with extremely high flow rates, analysis has shown that the rates in question do not result in unadequate saturation, but that instead variations are caused by some of the other sources of error referred to above.

According to the present invention there is provided a method for improving the accuracy in providing an uninterrupted, uniform mass flow of vapor in a chemical vapor delivery system including a container for holding a quantity of material to be vaporized and applied to a system which uses the vapor, means for ducting a carrier gas through said material to transport said vaporized material, a valve for controlling the flow of said carrier gas to said container, and means for controlling the temperature of the material in said container, characterized in that the method comprises:

continually sensing the total gaseous pressure in said container;

comparing said sensed pressure with a reference pressure to provide a pressure differential;

generating a control signal utilizing said pressure differential;

transmitting said control signal to said flow control valve to adjust said flow control valve to control the carrier gas flow to provide an uninterrupted uniform mass flow of said vaporized material to said using system.

Preferably the method of the present invention also includes steps of:

sensing the temperature of said material to be vaporized;

comparing said sensed temperature with a nominal temperature to determine a temperature differential; and

combining said temperature differential with said pressure differential to generate said control signal for providing said uniform mass flow of said vaporized material. In such an embodiment, there are preferably also the steps of

sensing the level of said material in said container;

determining changes in said sensed levels:

combining said changes in said sensed levels with said pressure differential to generate said signal for providing said uniform mass flow of said vaporized material to said using system.

The operation of the vapor mass flow controller of the present invention is based on the theory that accurate vapor mass flow from a liquid source bubbler can be obtained, if the temperature and pressure of the bubbler and the carrier gas, mass flow are known. In addition to these factors, an empirically observed correction factor, depending on bubbler geometry, temperature, liquid level, and flow rate must be applied. It should be noted that the change in correction factor due to bubbler geometry is small enough that the change can be ignored for normal bubbler manufacturing tolerances. Thus the correction factor normally only needs be determined for a particular design. This is important in that it makes the system more useful.

The concept is mathematically expressed as follows:

$$\dot{m} = \frac{\alpha F_c \bar{p}}{\underline{P} - \bar{p}} f\,(F_c,\ T,\ L)$$

where

$\dot{m}$ = Vapor mass flow
$F_c$ = Carrier gas mass flow
$\underline{P}$ = Total bubbler pressure
$f\,(F_c,\ T,\ L)$ = Empirical correction factor
$T$ = Bubbler temperature
$L$ = Liquid level in bubbler
$\bar{p} = \delta(\beta - \gamma/T$ = partial pressure of the chemical vapor that is the material vaporized from the liquid in the bubbler; and $\alpha$, $\beta$, $\gamma$ and $\delta$ = constants for the chemical liquid material in the bubbler.

By using the formula I above and properly measuring relevant parameters, temperature, pressure, level and carrier gas flow, an accurate determination of the vapor mass flow can be obtained. One or more of these parameters may be regulated through a feed back loop to control the vapor mass flow to any desired value within the available range of the parameters.

However it is possible to express formula I above in the form of approximate formula II, as more particularly described hereinbelow.

In a preferred example of the invention, changes in the variables are combined by an electronic flow controller which provides an output signal for adjusting the valve controlling the carrier gas flow, which provides the fastest adjustment speed. In addition, a signal is provided to a temperature controller for maintaining the bubbler temperature at a desired point. It has been found that with such a system, the accuracy of the vapor mass flow may be controlled to within one percent variation.

As additional features of the invention, the flow controller provides an alarm signal, if the level of liquid in the bubbler drops below a certain minimum required to obtain adequate saturation of the carrier gas. Additionally, the alarm indicates an overpressure condition and closes the input valve to interrupt the flow of carrier gas, if an overpressure condition should occur within the bubbler. A safety relief valve is also provided to relieve the pressure within the bubbler at a predetermined level.

According to the present invention there is also provided a chemical vapor delivery system for supplying uninterrupted, uniform mass flow of vaporized liquid to a using system, said delivery system comprising a bubbler container for holding a quantity of high purity liquid to be vaporized and applied to the using system; means for transporting a carrier gas through said liquid to transport the vaporized material to the using system; means for sensing the carrier gas flow rate; valve means for controlling the flow of said carrier gas; means for sensing and controlling the temperature of said liquid; characterized by further comprising means for sensing the total gaseous pressure in said container, and controller means connected to receive signals corresponding to the sensed temperature, the sensed pressure and the sensed carrier gas flow rate to produce a signal for controlling said carrier gas flow control valve means in a manner to produce an uninterrupted uniform mass flow of said vaporized liquid to said using system.

Preferably such apparatus includes means for sensing the level of liquid in said container, means for providing input from said level sensing means to said controller means which utilizes the changes in level of said liquid in determining the signal to be provided to said flow control valve means. The apparatus may also include means linked to said controller for interrupting flow of carrier gas into said container at a predetermined pressure, and, when such means are present, also preferably include (a) alarm means linked to said controller for providing an alarm signal if the flow of carrier gas into said bubbler container is interrupted, or (b) means for relieving pressure applied to said container at a predetermined pressure by venting said carrier gas to said using system.

The present invention will now be further described with reference to the accompanying drawings, in which:—

Figure 1 is a block diagram indicating the overall arrangement and operation of the system; and

Figure 2 is a block diagram indicating a mass flow approximation circuit of the electronic controller.

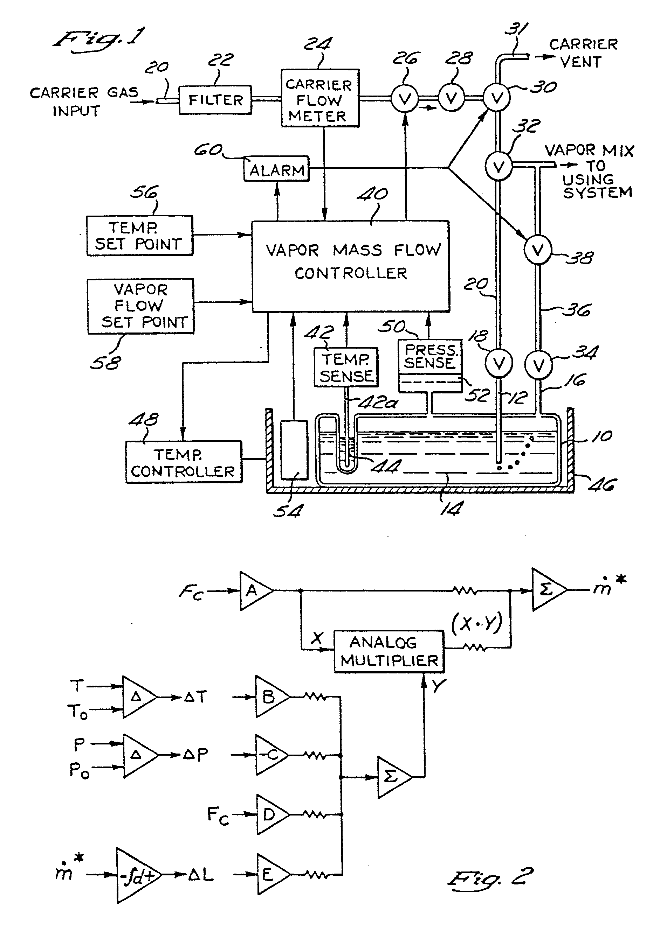

Referring to Figure 1, there is schematically illustrated a vaporizer bubbler 10 having an inlet tube 12 which enters through the upper wall of the bubbler and terminates at an open end near the bottom of the bubbler so that carrier gas exiting from the inlet tube will bubble upwardly through a quantity of liquid 14 within the bubbler container. The bubbler further has an outlet tube 16 in the upper wall of the bubbler in communication with the vapor space above the liquid in the bubbler. The bubbler is preferably made of high purity quartz material which will not react with the liquid or the carrier gas. Further details of two suitable bubblers may be obtained from U.S. Patents 4,134,514 and 4,140,735.

The bubbler inlet tube is connected by a manually operated valve 18 to a carrier gas inlet line 20. The upper end of the inlet line is connected to a suitable carrier gas input source. Moving downstream from the carrier gas input, there is positioned a filter 22, a carrier gas flow meter 24, a carrier gas flow control valve 26, a check valve 28, a three-way vent valve 30, and a pressure relief valve 32.

The bubbler outlet tube 16 is connected by manually operated valve 34 to an outlet line 36 past a shut-off valve 38 for connection to a using system (not shown). A typical using system is a batch of semiconductor wafers in a furnace in which the bubbler liquid vapor is to be deposited at an elevated temperature.

A vapor mass flow controller 40 receives a variety of input information and provides an output signal for controlling the flow control valve 26. One input is the temperature of the bubbler liquid 14 as measured by a temperature sensor 42 which includes a probe 42a extending into a thin-walled well 44 formed in the bubbler. The probe makes good thermal contact with the well by means of a heat transfer fluid positioned within the well.

The bubbler is positioned in a container or shell 46 for maintaining the bubbler at a desired temperature. The temperature controller 48 connected to the vapor mass flow controller 40 provides heat or extracts heat, to the container 46 to monitor the bubbler at a desired temperature level. Together, the container 46 and the controller 48 form a unit often referred to as a source-temperature controller (STC).

A pressure sensor or transducer 50 senses the pressure in the upper portion of the bubbler above the liquid and feeds a pressure input to the flow controller 40. The pressure transducer preferably includes an isolating diaphragm 52 which is exposed on one side to the bubbler interior, with the other side of the diaphragm confining a non-compressible fluid in the upper portion of the pressure sensor. The diaphragm 52 is preferably made of Teflon or some other suitable material which can resist the chemicals to be confined within the bubbler, while not introducing any contamination into the source material.

A suitable sensor 54 senses the level of the liquid in the bubbler and provides a level input signal to the flow controller 40. The sensor provides information for calculating the vapor flow and for determining when the chemical supply is depleted. The level can be determined by knowing the starting level and keeping track in the mass flow controller of the total volume of vapor lost to the carrier gas stream. Another method which can be used is to sense the level by means of light emitting and detecting devices on the inner walls of the container 46.

Suitable means 56 is provided for furnishing temperature set point information to the flow controller 40. Similarly, means 58 provides a vapor flow set point value to the controller. Also, the carrier gas flow meter 24 is connected to provide carrier gas flow information to the controller. As an additional feature of the system, an alarm 60 is provided to receive a signal from the controller if certain undesired conditions should occur such as an overpressure condition in the bubbler or a lack of sufficient liquid in the bubbler. The alarm means 60 is further connected to the inlet and outlet valves 30 and 38.

In operation, the bubbler is first connected to the system as shown, the manually operated valves 18 and 34 being connected to the bubbler inlet and outlet tubes in a manner to prevent contamination with respect to the bubbler liquid. The details of one suitable manner for making connections to a bubbler are described in U.S. Patent 4,134,514.

The temperature set point means 56 is adjusted to provide the desired temperature information to the controller 40. Similarly the desired vapor flow information is provided to the controller by the component 58. No pressure information need be provided by the user since the controller is preset for a standard of 101.3 kPa (760 millimeters of mercury). The temperature variation is relatively small with respect to a nominal temperature provided by the temperature set point means, and the pressure variation is also relatively small with respect to atmospheric pressure. Thus, the formula I for computing the vapor mass flow, $\dot{m}$, can be simplified in the following approximate formula, which is effectively a four-dimensional linear approximation of the formula expressed above:

$$\dot{m}^* = AF_c\ (1 + B\Delta T - C\Delta P - DF_c + E\Delta L) \qquad (II)$$

| | |
|---|---|
| $\dot{m}^*$ | =Approximate vapor mass flow |
| $F_c$ | =Carrier gas mass flow |
| $\Delta T$ | =Temperature variation from nominal- =$(T-T_o)$ |
| $\Delta P$ | =Pressure variation from nominal= $(P-P_o)$ |
| $\Delta L$ | =Change in liquid level=$-\int \dot{m}^* dt$ |
| A,B,C,D,E | =Positive constants computed for the chemical liquid material in the bubbler and nominal operating conditions |

This approximate formula can be easily implemented in analogue or digital electronics obvious to one skilled in that art. However, to further assist in understanding the electronics required by the controller, refer to the block diagram of Figure 2, which shows a mass flow approximation circuit. As can be seen, the variables in the system are amplified and combined to produce a multiplier for combining with the carrier gas mass flow to provide the approximate vapor mass flow. The electronics for such a system can be fabricated relatively inexpensively such that the controller becomes a very practical but yet highly accurate device.

Once the initial information has been fed to the controller and the bubbler is suitably connected to the system, the carrier gas is applied to the input line 20 with the vent valve 30 in open position so that the carrier gas is vented. After a short stabilization period, the valve 38 is opened, and the vent valve 30 moved to permit carrier gas flow into the bubbler. The valves 18 and 34 having been primarily employed to facilitate installation or removal of the bubbler without loss or contamination of chemicals. The system is then in operation and as variations in the sensed parameters occur, the information is sent to the controller which instantly provides an output signal to the automatic flow control valve 26 to adjust the valve in a manner to maintain a uniform flow of the vaporized source material 14 transported from the bubbler by the carrier gas to the using system.

In a typical example of the system used in connection with the fabrication of semiconductors, the bubbler might contain $POCl_3$, at a pressure of 101 kPa (760 mmHg). An inert carrier gas, such as nitrogen is provided at a flow rate of 0 to 500 standard cubic centimeters per minute. A pressure variation, $\Delta P$, is likely to be within the range of $-6.7$ to 20.3 kPa ($-50$ to $+152$ mmHg), with an approximation error of less than 2 percent in its worst case. Because the bubbler temperature is controlled so that its deviation is small, and the pressure deviation is similarly generally small, the nominal operating conditions are well within the approximation range of the approximate linear formula expressed above, and therefore the approximation error is much less than one percent.

If an overpressure condition is detected by the alarm means 60, the input valve 30 closes, and the output valve 38 opens, if it was not already open, to eliminate the overpressure condition. If valve 38 was open, it is locked open to prevent it from being closed while the overpressure condition exists. Additional safety is afforded by the pressure relief valve 32 which vents to the vapor output to prevent bubbler explosion in case of valve failure. The check valve 28 prevents corrosive bubbler liquid from reaching the carrier flow meter.

The foregoing system provides a reliable and practical means for maintaining the accurate vapor mass flow which is necessary in many chemical processes, particularly that used in the fabrication of semiconductor devices.

**Claims**

1. A method for improving the accuracy in providing an uninterrupted, uniform mass flow of vapor in a chemical vapor delivery system including a container (10) for holding a quantity of material to be vaporized and applied to a system which uses the vapor, means (20, 12, 16, 36) for ducting a carrier gas through said material to transport said vaporized material, a valve (26) for controlling the flow of said carrier gas to said container, and means (42, 48) for controlling the temperature of the material in said container, characterized in that the method comprises:

continually sensing the total gaseous pressure in said container;

comparing said sensed pressure with a reference pressure to provide a pressure differential;

generating a control signal utilizing said pressure differential;

transmitting said control signal to said flow control valve (26) to adjust said flow control valve to control the carrier gas flow to provide an uninterrupted uniform mass flow of said vaporized material to said using system.

2. A method as claimed in claim 1 including the steps of:

sensing the temperature of said material to be vaporized;

comparing said sensed temperature with a nominal temperature to determine a temperature differential; and

combining said temperature differential with said pressure differential to generate said control signal for providing said uniform mass flow of said vaporized material.

3. A method as claimed in claim 2 including:

sensing the level of said material in said container;

determining changes in said sensed level;

combining said changes in said sensed level with said pressure differential to generate said control signal for providing said uniform mass flow of said vaporized material to said using system.

4. A method as claimed in claim 3 wherein the sensed temperature, pressure, flow rate, and material level are utilized to provide uniform vapor mass flow in accordance with the approximate formula:

$$\dot{m}^* = AF_c \ (1 + B\Delta T - C\Delta P - DF_c + E\Delta L)$$

wherein

$$
\begin{aligned}
\dot{m}^* &= \text{Approximate vapor mass flow} \\
F_c &= \text{Carrier gas mass flow} \\
\Delta T &= \text{Temperature variation from nominal-} \\
&= (T - T_o) \\
\Delta P &= \text{Pressure variation from nominal-} \\
&= (P - P_o) \\
\Delta L &= \text{Change in liquid level} = -\int \dot{m}^* dt \\
A,B,C,D,E &= \text{Positive constants computed for the chemical material in the bubbler and nominal operating conditions.}
\end{aligned}
$$

5. A chemical vapor delivery system comprising a bubbler container (10) fr holding a quantity of high purity liquid to be vaporized and applied to a using system; means (20, 12, 16, 36) for transporting a carrier gas through said liquid to transport the vaporized material to the using system; means (24) for sensing the carrier gas flow rate; valve (26) means for controlling the flow of said carrier gas; and means for sensing (42) and controlling (48) the temperature of said liquid; characterised by further comprising means (50) for sensing the total gaseous pressure in said container, and controller means (40) connected to receive signals corresponding to the sensed temperature, the sensed pressure and the sensed carrier gas flow rate to produce a signal for controlling said carrier gas flow control valve means (26) in a manner to produce an uninterrupted uniform mass flow of said vaporized liquid to said using system.

6. An apparatus as claimed in claim 5 including means (54) for sensing the level of liquid in said container (10), means for providing input from said level sensing means to said controller means (40) which utilizes the changes in level of said liquid in determining the signal to be provided to said flow control valve means (26).

7. An apparatus as claimed in claim 5 including means (30) linked to said controller (40) for interrupting flow of carrier gas into said container (10) at a predetermined pressure.

8. An apparatus as claimed in claim 7 further including alarm means (60) linked to said controller (40) for providing an alarm signal if the flow of carrier gas into said bubbler container (10) is interrupted.

9. An apparatus as claimed in claim 7 including means (35) for relieving pressure applied to said container at a predetermined pressure by venting said carrier gas to said using system.

**Patentansprüche**

1. Verfahren zur Verbesserung der Genauigkeit, um einen ununterbrochenen, gleichmässigen Massenfluss von Dampf in einem chemischen Dampfentwicklungssystem zur Verfügung zu stellen, einschliessend einen Behälter (10) zur Aufnahme einer Menge des zu verdampfenden Materials, der an ein System, bei dem der Dampf verwendet wird, angeschlossen ist, Einrichtungen (20, 12, 16, 36), um ein Trägergas durch das Material zum Transportieren des verdampften Materials hindurchzuleiten, ein Ventil (26), um den Strom des Trägergas durch den Behälter zu kontrollieren, und Einrichtungen (42, 48) zur Kontrolle der Temperatur des Materials in dem Behälter, dadurch gekennzeichnet, dass das Verfahren umfasst:

kontinuierliches Abfühlen des Gesamtgasdrucks in dem Behälter;

Vergleichen des abgefühlten Druckes mit einem Vergleichsdruck unter Erhalt einer Druckdifferenz;

Erzeugen eines Kontrollsignals, welches von der Druckdifferenz Gebrauch macht;

Übertragen des Kontrollsignals zu dem Fliesskontrollventil (26) zur Einstellung des Fliesskontrollventils, um den Trägergasstrom so zu kontrollieren, dass ein ununterbrochener, gleichmässiger Massefluss des verdampften Materials in dem Verbrauchersystem zur Verfügung steht.

2. Verfahren gemäss Anspruch 1, einschliessend die Stufen;

Abfühlen der Temperatur des zu verdampfenden Materials;

Vergleichen der abgefühlten Temperatur mit einer nominalen Temperatur, um eine Temperaturdifferenz zu bestimmen; und

Kombinieren der Temperaturdifferenzt mit der Druckdifferenz unter Erzeugung des Kontrollsignals, um einen gleichförmigen Massestrom des verdampften Materials zur Verfügung zu stellen.

3. Verfahren gemäss Anspruch 2, einschliessend:

Abfühlen des Niveaus des Materials in dem Behälter;

Bestimmen von Veränderungen in dem abgefühlten Niveau;

Kombinieren der Veränderung in dem abgefühlten Niveau mit der Druckdifferenz zur Erzeugung des Kontrollsignals, um einen gleichförmigen Massestrom der verdampften Materials zu dem Verbrauchssystem zu Verfügung zu stellen.

4. Verfahren gemäss Anspruch 3, bei dem die abgefühlte Temperatur, der Druck, die Fliessrate und das Materialniveau verwendet werden, um einen gleichmässigen Dampfmassfluss, entsprechend der angenäherten Formel:

$$\dot{m}^* = AF_c\ (1 + B\Delta T - C\Delta P - DF_c + E\Delta L)$$

worin bedeuten:

$\dot{m}^*$ = angenäherter Dampfmassefluss
$F_c$ = Trägermassfluss
$\Delta T$ = Temperaturveränderung gegenüber der Nominaltemperatur = $(T - T_o)$
$\Delta P$ = Druckdifferenz gegenüber dem Normaldruck = $(P - P_o)$
$\Delta L$ = Veränderung des Flüssigkeitsniveaus = $-\int \dot{m}^* dt$
$A,B,C,D,E$ = positive Konstanten, die für das chemische Material in dem Perler und für die nominalen Betriebsbedingungen berechnet sind.

5. Chemisches Dampfabgabesystem, umfassend einen Gasspülbehälter (10) zur Aufnahme einer Menge einer hochrein zu verdampfenden Flüssigkeit, verbunden mit einem Verbrauchssystem; Einrichtungen (20, 12, 16, 36) zum Transportieren eines Trägergases durch die Flüssigkeit, um das verdampfte Material zu dem Verbrauchssystem zu transportieren; Einrichtungen (24), um die Trägergasfliessrate abzufühlen; eine Ventileinrichtung (26) zum Kontrollieren des Flusses des Trägergases; und Einrichtungen zum Abfühlen (42) und Kontrollieren (48) der Temperatur der Flüssigkeit, dadurch gekennzeichnet, dass sie weiterhin umfasst: Einrichtungen (50) zum Abfühlen des Gesamtgasdruckes in dem Behälter und Kontrolleinrichtungen (40), die so verbunden sind, um Signale entsprechend der abgefühlten Temperatur, dem abgefühlten Druck und der abgefühlten Trägergas-Fliessrate aufzunehmen, unter Ausbildung eines Signals für die Kontrolle der Trägergas - Fliesskontrollventileinrichtungen (26) derart, dass ein ununterbrochener, gleichförmiger Massefluss der verdampften Flüssigkeit zu dem Verbrauchssystem produziert wird.

6. Vorrichtung gemäss Anspruch 5, einschliessend Einrichtungen (54) zum Abfühlen des Flüssigkeitsniveaus in dem Behälter, Einrichtungen, um eine Eingabe von den Niveauabfühleinrichtungen zu den Kontrolleinrichtungen (40) zur Verfügung zu stellen, wodurch die Veränderungen in dem Flüssigkeitsniveau angewendet werden, um das Signal, welches bei den Fliesskontrollventileinrichtungen (26) vorgesehen ist, zu bestimmen.

7. Vorrichtung gemäss Anspruch 5, einschliessend Einrichtungen (3a), die mit der Kontrolleinrichtung (4a) zum Unterbrechen des Flusses des Trägergases in dem Behälter (10) bei einem vorbestimmten Druck verbunden sind.

8. Vorrichtung gemäss Anspruch 7, weiterhin einschliessend Alarmeinrichtungen (60), die mit der Kontrolleinrichtung (40) verbunden sind, um ein Alarmsignal zu geben, wenn der Fluss des Trägergases in dem Gasspülerbehälter (10) unterbrochen ist.

9. Vorrichtung gemäss Anspruch 7, einschliessend Einrichtungen (35) zum Ablassen des Druckes, welcher dem Behälter zugeführt wird bei einem vorbestimmten Druck, indem man das Trägergas zu dem Verbrauchssystem entlüftet.

## Revendications

1. Un procédé pour améliorer la précision de la formation d'un débit massique uniforme ininterrompu de vapeur dans un système chimique de distribution de vapeur comprenant un récipient (10) adapté à contenir une quantité de matière devant être vaporisée et envoyée à une installation qui utilise la vapeur, des moyens (20, 12, 16, 36) pour transférer un gaz porteur à travers ladite matière pour transporter ladite matière vaporisée, une soupape (26) pour commander le débit dudit gaz porteur vers ledit réservoir, et des moyens (42, 48) pour commander la température de la matière dans ledit réservoir, caractérisé en ce qu'il comprend:

le repérage continu de la pression gazeuse totale dans ledit réservoir;

la comparaison de ladite pression repérée avec une pression de référence pour obtenir une différence de pression;

la production d'un signal de commande en utilisant ladite différence de pression;

la transmission dudit signal de commande à ladite soupape de commande de débit (26) pour régler ladite soupape de commande de débit afin qu'elle commande le débit de gaz porteur pour obtenir un débit massique uniforme ininterrompu de ladite matière vaporisée vers ladite installation d'utilisation.

2. Un procédé selon la revendication 1, incluant les phases de:

repérage de la température de ladite matière à vaporiser;

comparaison de ladite température repérée avec une température nominale pour définir une différence de température; et

combinaison de ladite différence de température avec ladite différence de pression pour générer ledit signal de commande afin de produire ledit débit massique uniforme de ladite matière vaporisée.

3. Un procédé selon la revendication 2, incluant:

le repérage du niveau de ladite matière dans ledit réservoir;

la détermination des variations dudit niveau repéré;

la combinaison des variations dudit niveau détecté avec ladite différence de pression pour générer ledit signal de commande afin de produire ledit débit massique uniforme de ladite matière vaporisée vers ladite installation d'utilisation.

4. Un procédé selon la revendication 3, dans lequel la température, la pression, le débit et le niveau de matière repérés sont utilisés pour produire un débit massique de vapeur uniforme conformément à la formule approximative:

$$\dot{m}^* = AF_c\ (1+B\Delta T-C\Delta P-DF_c+E\Delta L)$$

dans laquelle

| | |
|---|---|
| $\dot{m}^*$ | =débit massique approximatif de vapeur |
| $F_c$ | =débit massique de gaz porteur |
| $\Delta T$ | =écart de température à partir de la valeur nominale=$(T-T_o)$ |
| $\Delta P$ | =écart de pression à partir de la valeur nominale=$(P-P_o)$ |
| $\Delta L$ | =variation de niveau du liquide= $-\int \dot{m}^* dt$ |
| A,B,C,D,E | =constantes positives calculées pour la matière chimique dans le réservoir de barbotage et pour des conditions de fonctionnement normales. |

5. Un système chimique de fourniture de vapeur comportant un réservoir de barbotage (10) pour contenir une certaine quantité de liquide de grande pureté devant être vaporisé et envoyé à un système d'utilisation, des moyens (20, 12, 16, 36) pour le transport d'un gaz porteur à travers ledit liquide pour transporter la matière vaporisée au système d'utilisation, des moyens (24) pour détecter le débit de gaz porteur, un moyen à soupape (26) pour commander le débit dudit gaz porteur, et des moyens de repérage (42) et de commande (48) de la température dudit liquide, caractérisé en ce qu'il comporte en outre des moyens (50) de repérage de la pression gazeuse totale dans ledit réservoir, et des moyens régulateurs (40) branchés pour recevoir des signaux correspondant à la température repérée, à la pression repérée et au débit de gaz porteur repéré pour produire un signal de commande dudit moyen à soupape (26) de commande de débit de gaz porteur de façon à produire un débit massique uniforme ininterrompu dudit liquide vaporisé vers ledit système d'utilisation.

6. Un appareil selon la revendication 5, comportant des moyens (54) de repérage du niveau du liquide dans ledit reservoir (10), des moyens de fourniture des informations d'entrée provenant desdits moyens de repérage de niveau auxdits moyens régulateurs (40) qui utilisent les variations du niveau dudit liquide pour déterminer le signal à envoyer audit moyen à soupape (26) de commande de débit.

7. Un appareil selon la revendication 5, comportant des moyens (30) reliés auxdits moyens régulateurs (40) pour interrompre l'écoulement du gaz porteur dans ledit réservoir (10) à une pression prédéterminée.

8. Un appareil selon la revendication 7, comportant en outre des moyens d'alarme (60) reliés auxdits moyens régulateurs (40) pour fournir un signal d'alarme si l'écoulement du gaz porteur dans ledit réservoir de barbotage (10) est interrompu.

9. Un appareil selon la revendication 7, comportant des moyens (35) d'atténuation de la pression appliquée audit récipient à une pression prédéterminée en évacuant ledit gaz porteur allant audit système d'utilisation.

Fig.1

Fig. 2